(19)

Europäisches
Patentamt
European
Patent Office
Office européen
des brevets

(11)  **EP 1 306 910 B1**

(12)  **EUROPEAN PATENT SPECIFICATION**

(45) Date of publication and mention
of the grant of the patent:
**17.08.2011  Bulletin 2011/33**

(51) Int Cl.:
***H01L 51/05*** *(2006.01)*

(21) Application number: **02447197.1**

(22) Date of filing: **15.10.2002**

(54) **Ambipolar organic transistors**

Ambipolarer organischer Transistor

Transistor organique ambipolaire

(84) Designated Contracting States:
**AT BE BG CH CY CZ DE DK EE ES FI FR GB GR
IE IT LI LU MC NL PT SE SK TR**

(30) Priority: **24.10.2001 EP 01870226**

(43) Date of publication of application:
**02.05.2003  Bulletin 2003/18**

(73) Proprietors:
 • **IMEC
  3001 Leuven (BE)**
 • **Agfa-Gevaert N.V.
  2640 Mortsel (BE)**
 • **LIMBURGS UNIVERSITAIR CENTRUM
  3590 Diepenbeek (BE)**

(72) Inventors:
 • **Geens, Wim
  2860 Sint-Katelijne-Waver (BE)**
 • **Poortmans, Jef
  3010 Kessel-Lo (BE)**
 • **Aernouts, Tom
  3120 Tremelo (BE)**
 • **Andriessen, Hieronymus
  2340 Beerse (BE)**
 • **Vanderzande, Dirk
  3500 Hasselt (BE)**

(74) Representative: **Van Malderen, Joëlle et al
pronovem - Office Van Malderen
Avenue Josse Goffin 158
1082 Bruxelles (BE)**

(56) References cited:
**EP-A- 0 716 459**

 • **GEENS W ET AL: "Field-effect mobility
 measurements of conjugated polymer/fullerene
 photovoltaic blends" ELECTRONIC
 PROPERTIES OF NOVEL MATERIALS -
 MOLECULAR NANOSTRUCTURES. 14TH
 INTERNATIONAL WINTERSCHOOL/
 EUROCONFERENCE, KIRCHBERG, AUSTRIA,
 4-11 MARCH 2000, no. 544, pages 516-520,
 XP008001919 AIP Conference Proceedings, 2000,
 AIP, USA ISSN: 0094-243X**
 • **BRABEC C J ET AL: "ORGANIC PHOTOVOLTAIC
 DEVICES PRODUCED FROM CONJUGATED
 POLYMER/METHANOFULLERENE BULK
 HETEROJUNCTIONS" SYNTHETIC METALS,
 ELSEVIER SEQUOIA, LAUSANNE, CH, vol. 121,
 no. 1-3, 15 March 2001 (2001-03-15), pages
 1517-1520, XP001020485 ISSN: 0379-6779**

## Description

## Field of the invention

The present invention is related to microelectronics and more particularly to ambipolar organic field-effect transistors comprising organic active layer material.

## State of the art

Organic transistors and more particularly thin film field-effect transistors become more and more attractive in electronics because of their low-cost deposition technologies and steadily improving performance.

An organic field-effect transistor consists of materials ranging from conductors and semiconductors, to insulators.

A transistor is namely p-channel if the majority charge carriers in the channel are positive (holes), and conversely n-channel when the majority charge carriers in the channel are negative (electrons).

Complementary circuits consist of both n-channel and p-channel transistors. They are particularly useful because of advantages such as low static power dissipation and simple circuit design.

For the fabrication of organic complementary circuits the organic semiconducting p-channel and n-channel materials should exhibit relatively high and comparable mobility values for holes as well as for electrons.

Ambipolar operation has been observed in organic field-effect transistors based on ultra-pure pentacene single crystals (Schön et al., Science, Vol. 287 (2000) p1022-1023).

In the single crystals, which were grown by physical vapour transport in a stream of nitrogen, accumulation (p-type) and inversion (n-type) could be established.

However, low-cost solution-processable complementary circuits require the use of two different organic materials to obtain n-channel and p-channel transistors, since defects in these materials only allow unipolar charge transport.

There are several reasons why only a limited number of high performance n-channel organic semiconductors have been discovered so far, one of them is the fact that most organic materials tend to transport holes better than electrons and a large research effort is ongoing on electron transporters. In this field the major difficulty is to find a material which is not sensitive to oxygen. Oxygen is known to be an efficient trap for electrons.

Recent developments disclose organic transistor structures, comprising a mix of two active materials which enables p-channel and n-channel operations in the same device. An example of such active materials exhibiting such properties are poly(3-hexylthiophene) (P3HT) and N,N'-bis(2,5-di-*tert*-butylphenyl)-3,4,9,10-perylene dicarboximide (BPPC) as respectively hole and electron transporters.(Tada et al., Jpn. J. Appl. Phys., Vol. 36 (1997) Pt. 2, No. 6A, L718). Currents of both polarities can be injected from the source and the drain contacts.

Such transistors are n-channel under positive gate bias and p-channel under negative gate bias. Hole and electron mobilities of respectively $< 10^{-6}$ cm$^2$/(Vs) and $< 10^{-7}$ cm$^2$/(Vs) were reported for P3HT doped with a 25 mol % concentration of BPPC.

Balberg describes in Applied Physical Letters , Vol.79,No.2,9 July 2001 a fullerene ($C_{60}$)-polymer network composite structure showing as well a connectivity of a percolative $C_{60}$ network and additionally a connectivity of the polymer network. The effectivity of the coupling phenomenon and the recombination kinetics depends on the molar fractions of both components.

Brown discloses in U.S.Patent 5,629,530 a solid state mixture of organic donor and acceptor molecules different from the present invention and encounters some difficulties to obtain good balanced mobility values for holes and electrons transports in his organic donor/acceptor layer.

Dodabalapur discloses in U.S.Patent 5,596, 208 organic field-effect transistors based on superposed evaporated organic n-type and p-type layers. In this patent evaporated $C_{60}$ molecules are used as electron transporters in combination with Cr/Au bottom contacts. This technology leads to high production costs and this is a major disadvantage for organic transistors which are especially developed for low cost applications.

In 2000 Geens et. al in CP544, Electronic Properties of Novel Materials - Molecular Structures, ed. H. Kuzmany et al., Americal Institute of Physics, pages 516-520 reported field effect mobility measurements of organic field-effect transistors using an active region consisting of a conjugated polymer poly(2-methoxy-5-(3',7'-dimethyloctyloxy)-1,4-phenylene-vinylene (MDMO-PPV) blended with a soluble derivative of C60 (6,6)-phenyl C61-butyric acid methyl ester (PCBM) in ratios of 1:2, 1:3, 1:4 and 1:10 with gold source and drain electrode, p-conducting silicon as the gate electrode and a silica insulating layer.

Geens et al. did not report any transistor with ambipolar properties. In 2000 Brabec at al. in Synthetic Metals, volume 121, pages 1517-1520, reported bulk heterojunction photovoltaic devices based on a spin-coated blend of MDVO-PPV and PCBM. Devices with power efficiencies higher than 2.5% under AM1.5 were reported.

Geens et al. in "14th Internat Winterschool/Euroconference, Kirchberg, Austria, 4-11. March 2000, & AIP Conference Proceedings 544 (2000) 516-520", discloses field effect mobility measurements of bipolar organic field-effect transistors using an active region consisting of a conjugated polymer poly(2-methoxy-5-(3',7'-dimethyloctyloxy)-1,4-phenylene-vinylene (MDMO-PPV) blended with a soluble derivative of C60 (6,6)-phenyl C61-butyric acide methyl ester (PCBM) in ratios of 1:2, 1:3, 1:4 and 1:10 with gold source and drain electrodes, p-conducting silicon as the gate electrode and a silica insulating layer.

Brabec et al. in Synthetic Metals 121 (2001) 1517-1520, discloses bulk heterojunction photovoltaic devices based on a spin-coated blend of MDVO-PPV and PCBM.

## Aims of the invention

The present invention aims to provide a network of organic molecules providing high balanced mobility values for holes and electrons combined to single top contacts for low-cost large scale organic ambipolar transistor productions.

## Summary of the invention

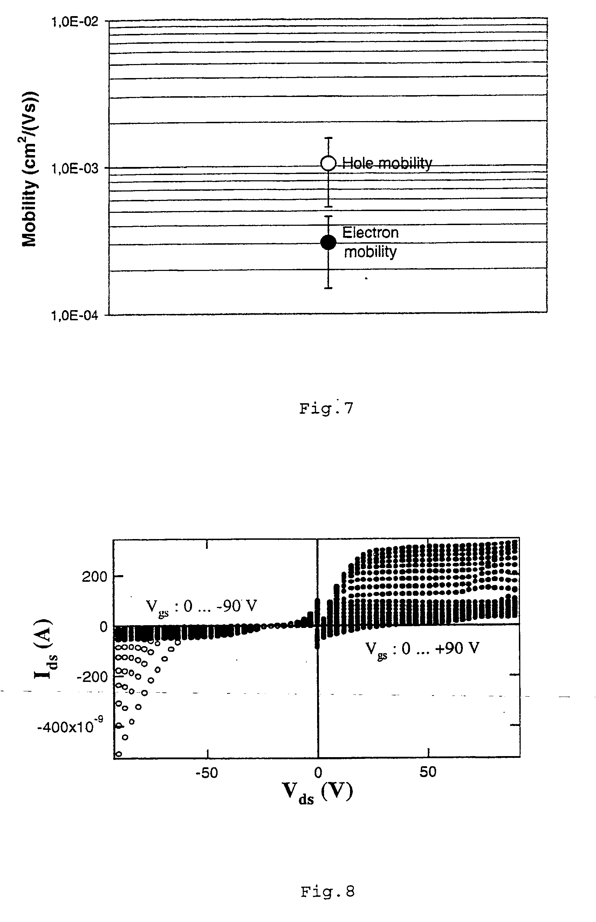

It has been surprisingly found that organic field-effect transistors using known blends of $OC_1C_{10}$-PPV and PCBM, which exhibited high hole mobilities with Au source and drain electrodes, become ambipolar upon using source and drain electrodes comprising Au, LiF and Al exhibiting hole field-effect mobilities of $2 \times 10^{-5}$ $cm^2/Vs$ and electron field effect mobilities of $2 \times 10^{-4}$ $cm^2/Vs$ as determined from the saturation regime. These field effect mobilities were surprisingly found to be comparable with hole and electron field-effect mobilities exhibited by organic field-effect transistors with Au source and drain electrodes ($1 \times 10^{-3}$ $cm^2/Vs$) and LiF/Al source and drain electrodes ($3 \times 10^{-4}$ $cm^2/Vs$) respectively as described in Figure 7.

Accordingly, the present invention relates to an organic field-effect transistor and to a process for preparing a field-effect transistor as defined in the appended claims.

The present invention discloses a thin film ambipolar organic metal oxide semiconductor field-effect transistor (MOSFET) comprising source and drain contacts and an organic semiconductor layer, said layer comprises hole and electron transporter, characterised in that said electron transporter comprises (6,6)-phenyl $C_{61}$-butyric acid methyl ester (PCBM) and said hole transporter comprises poly(2-methoxy-5-(3',7'-dimethyloctyloxy)-1,4-phenylene-vinylene) ($OC_1C_{10}$-PPV) and/or poly(3-hexylthiophene)(P3HT)

In a particular aspect of the invention the organic semiconductor layer comprises a blend of $OC_1C_{10}$-PPV : PCBM in weight proportions of (1:4).

A preferred aspect of the present invention is that the organic $OC_1C_{10}$-PPV : PCBM mix is dissolved in chlorobenzene or in 1,2-dichlorobenzene or xylene.

According to the present invention, source and drain electrodes independently comprise LiF and Al and Au.

In a further preferred embodiment of the present invention the source and drain contacts are a codeposited (< 1 nm thick) Au/LiF layer in weight ratios in the range 10:1 to 1:10, followed by the deposition of an Al layer.

## Short description of the drawings

Fig.1 represents a schematic device structure of the thin film transistor with top source and drain electrodes (1), an organic semiconductor layer (2), an insulation layer (3) and a gate contact (4).

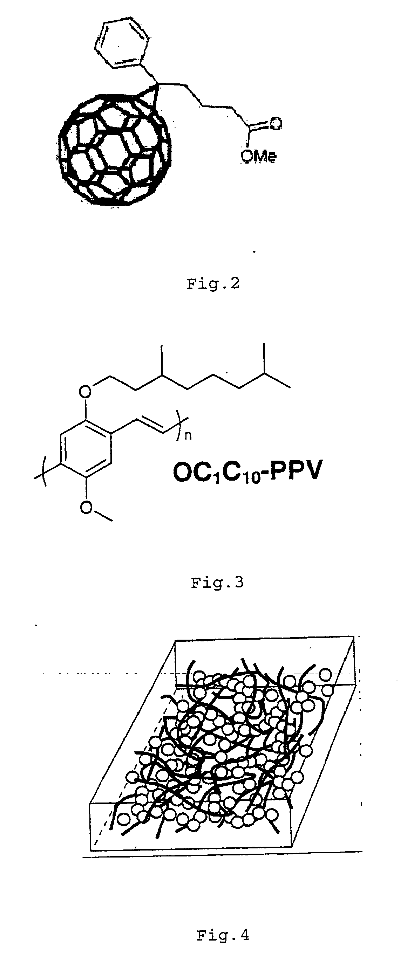

Fig.2 represents the molecule used as electron transporter. This is a modified soluble fullerene for spin coating applications, (6,6)-phenyl $C_{61}$-butyric acid methyl ester, (PCBM).

Fig.3 represents the molecule used as hole transporter poly(2-methoxy-5-(3',7'-dimethyloctyloxy)-1,4-phenylene-vinylene), ($OC_1C_{10}$-PPV).

Fig.4 represents a schematic view of the assembling of the molecules in the organic layer, building some electron and hole transport channels.

Fig.5 represents the p-channel electrical characteristics of a field-effect transistor with an active layer of a (1:4) weight ratio blend of $OC_1C_{10}$-PPV : PCBM and Au top contacts.

Fig.6a represents the n-channel electrical characteristics of a field-effect transistor with an active layer of a (1:4) weight ratio blend of $OC_1C_{10}$-PPV : PCBM and Al top contacts.

Fig.6b represents the improved n-channel electrical characteristics of a field-effect transistor with an active layer of a (1:4) weight ratio blend of $OC_1C_{10}$-PPV : PCBM with LiF/Al top contacts. A thin layer of LiF was evaporated on top of the organic blend prior to the deposition of the Al electrode.

Fig.7 represents the hole and electron mobilities in $OC_1C_{10}$-PPV : PCBM (1:4) weight ratio as determined from devices with respectively Au top contacts and LiF/Al top contacts.

Fig.8 represents the p-channel and n-channel electrical characteristics of a field-effect transistor with an active layer of a (1:4) weight ratio blend of $OC_1C_{10}$-PPV : PCBM with Au:LiF/Al top contacts. A thin layer of co-evaporated Au and LiF (represented as (Au: LiF)) in a (1:1) weight ratio was formed on top of the organic blend prior to the deposition of the Al electrode.

## Detailed description of the invention

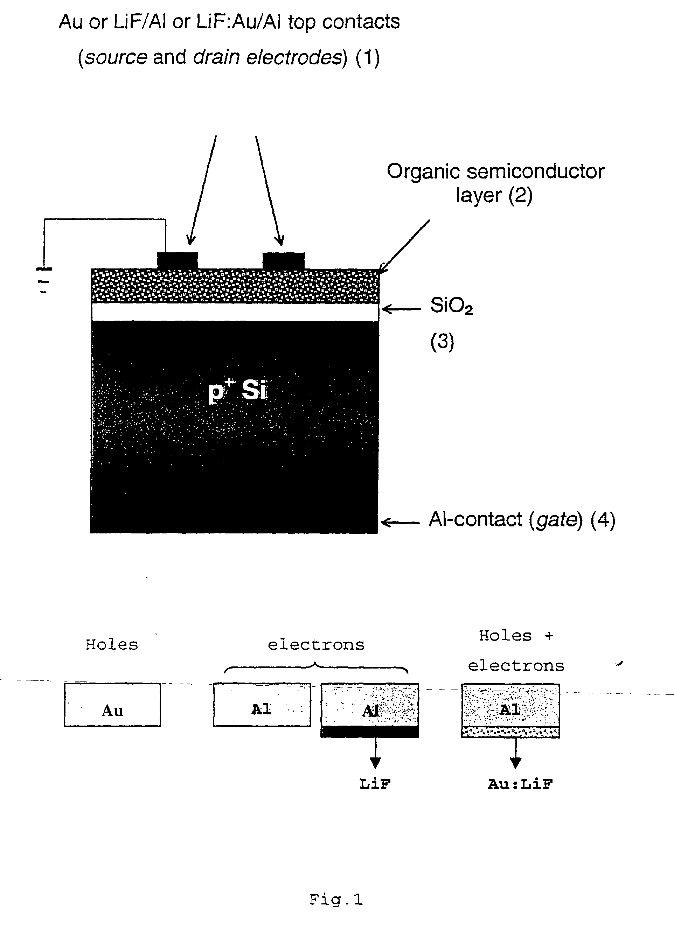

Fig.1 shows the set-up of the organic field-effect transistor and helps [to understand] the experimental conditions of the different steps to be understood. In Figure 1 the gate electrode is a self-supporting piece of doped silicon coated with an insulating silica layer on one side and contacted with aluminium gate contact (4) on the other.

In a first cleaning step, the $SiO_2$ surface is properly cleaned by immersing the substrate consecutively in heated acetone and heated IPA (isopropylalcohol).

In a second step a surface treatment of the $SiO_2$ is performed by an oxygen plasma during 5 minutes at 200 W. This step is followed by a HMDS (hexamethyldisilazane) treatment.

This treatment leads to an extremely hydrophobic $SiO_2$ surface.

The self-supporting piece of doped silicon coated with an insulating silica layer on one side and contacted with aluminium gate contact (4) on the other is then introduced into a nitrogen box where spin coating of the organic semiconductor layer onto the insulating silica layer can be carried out. The presence of nitrogen keeps oxygen and moisture out of the organic semiconductor layer [film]. Furthermore, the self-supporting piece of doped silicon coated with an insulating silica layer coated on one side and contacted with aluminium gate contact (4) on the other, now coated with the organic semiconductors layer, can be directly transferred from the nitrogen box to the metal deposition chamber in this way avoiding the formation of an insulating metal oxide layer at the interface between the organic semiconductor layer and the evaporated metal.

The organic blends are prepared by dissolving $OC_1C_{10}$-PPV and PCBM in a (1:4) weight ratio in an organic solvent, preferably, water-free chlorobenzene, water-free 1,2-dichlorobenzene or xylene. In practice, 5mg of $OC_1C_{10}$-PPV and 20mg of PCBM are dissolved in 1ml of one of the above mentioned solvents. A magnetic stirring rod is added to the solution in a vessel and is kept stirring overnight at a temperature of 60 °C. The organic layer is formed by covering the $SiO_2$ with the solution and spincoat the surface 40s at 1200 rpm, followed by 20s at 4000 rpm. This technique supplies organic layers of suitable thickness (100 to 200 nm). A similar technique can be used for poly(3-hexylthiophene)(P3HT).

In the next step the top electrodes are evaporated through a shadow mask defining channel lengths ranging between 30 microns and 200 microns and channel widths of 2 mm or 10 mm.

Different types of top contacts can be formed:

- for hole transport: Au(100 nm)
- for electron transport: LiF(0.6 nm)/Al(120 nm)
- for electron and hole transport: Au:LiF (0.6 nm)/Al (120 nm)

In latter case first a very thin layer is formed by the co-evaporation of Au and LiF at an extremely low deposition rate, typically 0.1 Angstrom/sec or 10pm/sec for Au as well as for LiF. In this way a mixed layer of 0.6 nm Au:LiF could be formed in 30 seconds. This step is followed by the deposition of an Al layer of approximately 120 nm thickness.

The work function of Au is such that it forms an ohmic contact with the highest occupied molecular orbital (HOMO) of $OC_1C_{10}$-PPV, resulting in a low injection barrier for the holes.

A low injection barrier for the electrons into the lowest unoccupied (LUMO) of PCBM was realised by depositing LiF/Al drain and source contact electrodes on-

to the organic blend. The co-deposition of Au and LiF, followed by the deposition of Al was surprisingly found to combine these two properties.

After the set-up of the different functional layers on the organic field-effect transistor, the samples were taken out of the deposition chamber and measured in a flow of nitrogen.

FET characterisation was performed using a HP4156A analyser, with the source contact connected to ground.

The measurement mode of the FET is determined by the gate voltage, which induces an accumulation layer of charges in the region of the conduction channel adjacent to the interface with the $SiO_2$.

For $p$-channel · ($n$-channel) operation, a negative (positive) gate voltage is applied to induce an accumulation layer of holes (electrons), allowing the measurement of the hole (electron) mobility. The field-effect mobilities $\mu_{FE}$ were calculated from the saturation regime of the drain-source current ($I_{ds}$) using the formula:

$$I_{ds_{sat}} = \frac{\mu_{FE} W C_{ox}}{2L} \left( V_{gs} - V_t \right)^2$$

where $W$ and $L$ are respectively the conduction channel width and length, $C_{ox}$ is the capacitance of the insulating $SiO_2$ layer, $V_{gs}$ is the gate voltage, and $V_t$ is the threshold voltage.

We have determined the following mobilities:

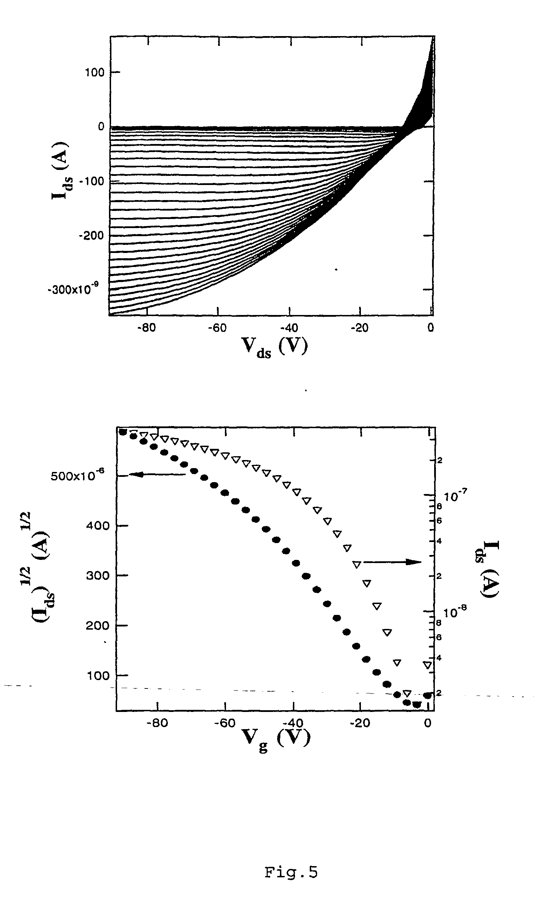

For the hole mobility, Au contacts $\rightarrow \mu_h$ = 1 x $10^{-3}$ $cm^2$/ (Vs) (Fig. 5)

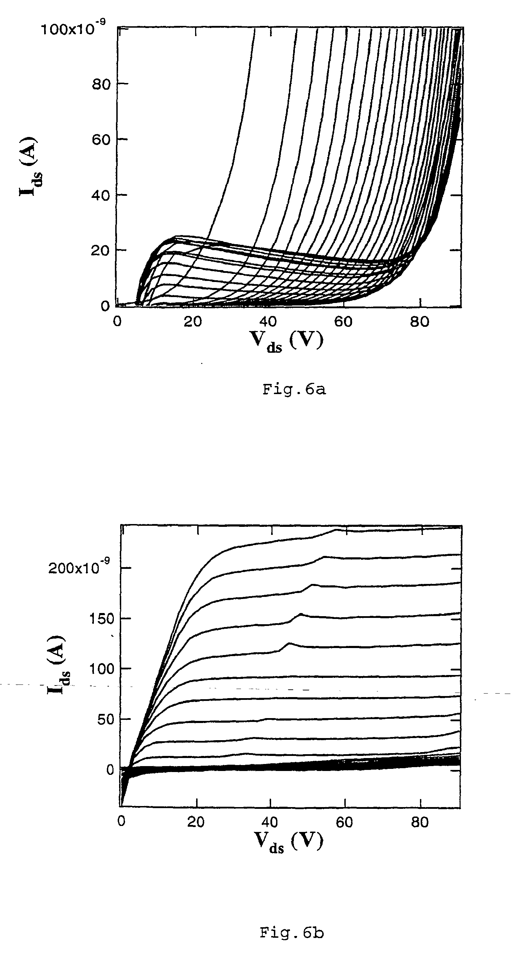

For the electron mobility, LiF/Al contacts $\rightarrow \mu_e$ = 3 x $10^{-4}$ $cm^2$/(Vs) (Fig. 6)

The previous mobility values are summarised in Fig. 7 with their respective error bars.

For the hole and electron mobility at the same time, Au:LiF/Al with a (1:1) ratio for (Au:LiF) $\rightarrow \mu_h$ = 2 x $10^{-5}$ $cm^2$/ (Vs) and $\mu_e$ = 2 x $10^{-4}$ $cm^2$/ (Vs) (Fig. 8).

**Claims**

1. An organic field-effect transistor comprising separate source and drain electrodes independent of one another on a layer configuration, said layer configuration comprising at least an organic semiconductor layer constituting a channel between said source and drain electrodes, an insulation layer underlying said organic semiconductor layer and a gate electrode formed on the opposite side of the isolation layer, wherein said organic semiconductor layer comprises hole and electron transporters, **characterized in that** said electron transporters comprise (6,6)-phenyl $C_{61}$-butyric acid methyl ester (PCBM) and said hole transporters comprise poly(2-methoxy-5-(3',7'-dimethyloctyloxy)-1,4-phenylene-vinylene) ($OC_1$-$C_{10}$-PPV) and/or poly(3-hexylthiophene) (P3HT), and said source and drain electrodes independently comprise LiF and Al and Au.

2. Organic field-effect transistor according to claim 1, wherein said source electrode and/or said drain electrode comprises Au and LiF in a weight ratio in the range of 1:10 to 10:1.

3. Organic field-effect transistor according to claim 2, wherein said source electrode and/or said drain electrode comprises Au and LiF in a weight ratio in the range of 1:1 to 4:1.

4. Organic field-effect transistor according to claim 1, wherein said source electrode and/or said drain electrode comprises codeposited Au and LiF.

5. Organic field-effect transistor according to claim 4, wherein an Al layer is deposited on top of said codeposited Au/LiF layer.

6. Organic field-effect transistor according to claim 1, wherein said source electrode and/or said drain electrode comprises an LiF/Al contact to said organic semiconductor layer.

7. Organic field-effect transistor according to claim 1, wherein said organic semiconductor layer comprises a blend of $OC_1C_{10}$-PPV : PCBM in a weight ratio in the range 0.5:1 to 5:1.

8. Organic field-effect transistor according to claim 1, wherein said organic semiconductor layer comprises traces of an organic solvent.

9. Organic field-effect transistor according to claim 8, wherein said organic semiconductor layer comprises traces of at least one organic solvent selected from the group consisting of chlorobenzene, 1,2 dichlorobenzene and xylene.

10. A process for preparing an organic field effect transistor comprising the following steps:

    - providing a gate electrode or forming a gate electrode on a substrate,
    - depositing on said gate electrode an insulating layer preferably a $SiO_2$ layer,

    **characterized in that**

    - on said insulating layer an organic semiconductor layer is deposited comprising a mixture of at least two components, the first component being (6,6)-phenol $C_{61}$-butyric acid methyl ester and the second component being poly(2-methoxy-5-(3', 7'-dimethyloctyloxy)-1,4-phenylene-vinylene)($OC_1C_{10}$-PPV) and/or poly(3-hexylthiophene) (P3HT), and
    - a source and a drain electrode are created independently of one another, both said source and drain electrodes comprising LiF and Al and Au.

11. Process according to claim 10, wherein said creation of said source and drain electrodes is performed by codeposition of Au and LiF in a weight ratio in the range of 1:10 to 10:1.

12. Process according to claim 11, wherein said codeposition of Au and LiF is followed by the deposition of an Al layer.

13. Process according to claim 10, wherein said organic semiconductor layer is deposited from a solution or dispersion in one or more organic solvents.

14. Process according to claim 10, wherein said organic semiconductor layer is deposited by spray-drying.

**Patentansprüche**

1. Organischer Feldeffekttransistor welcher getrennte voneinander unabhängige Source- und Drain-Elektroden auf einer Schichtkonfiguration umfasst, die Schichtkonfiguration mindestens eine organische Halbleiterschicht, welche einen Kanal zwischen der Source- und Drain-Elektrode bildet, eine unter der organischen Halbleiterschicht angeordnete Isolierschicht und eine auf der gegenüberliegenden Seite der Isolierschicht ausgebildete Gate-Elektrode umfassent, wobei die organische Halbleiterschicht Loch- und Elektronentransporter umfasst, **dadurch gekennzeichnet, dass** die Elektronentransporter (6,6)-Phenyl $C_{61}$-Buttersäuremethylester (PCBM) umfassen und die Lochtransporter Poly(2-methoxy-5-(3', 7'-dimethyloctyloxy)-1,4-Phenylen-Vinylen) ($OC_1C_{10}$-PPV) und/oder Poly(3-Hexylthiophen) (P3HT) umfassen, und die Source- und Drain-Elektrode unabhängig voneinander LiF und Al und Au umfassen.

2. Organischer Feldeffekttransistor nach Anspruch 1, wobei die Source-Elektrode und/oder die Drain-Elektrode Au und LiF in einem Gewichtsverhältnis im Bereich von 1:10 bis 10:1 umfassen.

3. Organischer Feldeffekttransistor nach Anspruch 2, wobei die Source-Elektrode und/oder die Drain-Elektrode Au und LiF in einem Gewichtsverhältnis im Bereich von 1:1 bis 4:1 umfassen.

4. Organischer Feldeffekttransistor nach Anspruch 1, wobei die Source-Elektrode und/oder die Drain-Elektrode gemeinsam aufgebrachtes Au und LiF umfassen.

5. Organischer Feldeffekttransistor nach Anspruch 4, wobei oben auf die gemeinsam aufgebrachte Au/LiF-Schicht eine Al-Schicht aufgebracht ist.

6. Organischer Feldeffekttransistor nach Anspruch 1, wobei die Source-Elektrode und/oder die Drain-Elektrode einen LiF/Al-Kontakt zu der organischen Halbleiterschicht umfassen.

7. Organischer Feldeffekttransistor nach Anspruch 1, wobei die organische Halbleiterschicht eine Mischung aus $OC_1C_{10}$-PPV : PCBM in einem Gewichtsverhältnis im Bereich von 0,5:1 bis 5:1 umfasst.

8. Organischer Feldeffekttransistor nach Anspruch 1, wobei die organische Halbleiterschicht Spuren eines organischen Lösungsmittels umfasst.

9. Organischer Feldeffekttransistor nach Anspruch 8, wobei die organische Halbleiterschicht Spuren mindestens eines organischen Lösungsmittels umfasst, das aus der Gruppe ausgewählt ist die aus Chlorbenzol, 1,2-Dichlorbenzol und Xylol besteht.

10. Verfahren zur Herstellung eines organischen Feldeffekttransistors, welches die folgenden Schritte umfasst:

   - Bereitstellen einer Gate-Elektrode oder Bilden einer Gate-Elektrode auf einem Substrat,
   - Aufbringen einer Isolierschicht, vorzugsweise einer $SiO_2$-Schicht, auf die Gate-Elektrode,

   **dadurch gekennzeichnet, dass**

   - auf die Isolierschicht eine organische Halbleiterschicht aufgebracht wird welche ein Gemisch aus mindestens zwei Komponenten umfasst, wobei es sich bei der ersten Komponente um (6,6)-Phenyl $C_{61}$-Buttersäuremethylester (PC-BM) handelt und bei der zweiten Komponente um Poly(2-methoxy-5-(3',7'-dimethyloctyloxy)-1,4-Phenylen-Vinylen) ($OC_1C_{10}$-PPV) und/oder Poly(3-Hexylthiophen) (P3HT) handelt, und
   - eine Source- und Drain-Elektrode unabhängig voneinander erzeugt werden, wobei sowohl Sourceals auch Drain-Elektrode LiF und Al und Au umfassen.

11. Verfahren nach Anspruch 10, wobei die Erzeugung der Source- und Drain-Elektrode durch gemeinsames Aufbringen von Au und LiF in einem Gewichtsverhältnis im Bereich von 1:10 bis 10:1 durchgeführt wird.

12. Verfahren nach Anspruch 11, wobei nach dem gemeinsamen Aufbringen von Au und LiF das Aufbringen einer Al-Schicht folgt.

13. Verfahren nach Anspruch 10, wobei die organische Halbleiterschicht aus einer Lösung oder Dispersion in einem oder mehreren organischen Lösungsmitteln deponiert wird.

14. Verfahren nach Anspruch 10, wobei die organische Halbleiterschicht durch Sprühtrocknung deponiert wird.

**Revendications**

1. Transistor à effet de champ organique comprenant des électrodes de sources et de drain séparées, indépendantes l'une de l'autre sur une configuration de couches, ladite configuration de couches comprenant au moins une couche de semi-conducteur organique constituant un canal entre lesdites électrodes de source et de drain, une couche d'isolation sous-jacente à ladite couche de semi-conducteur organique et une électrode de grille formée sur le côté opposé de la couche d'isolation, dans lequel ladite couche de semi-conducteur organique comprend des transporteurs de trous et d'électrons, **caractérisé en ce que** lesdits transporteurs d'électrons comprennent de l'ester méthylique d'acide (6,6)-phényl-$C_{61}$-butyrique et lesdits transporteurs de trous comprennent du poly(2-méthoxy-5-(3',7'-diméthyloctyloxy)-1,4-phénylène-vinylène) ($OC_1C_{10}$-PPV) et/ou du poly(3-hexylthiophène) (P3HT), et lesdites électrodes de source et de drain comprennent indépendamment du LiF et de l'Al et de l'Au.

2. Transistor à effet de champ organique selon la revendication 1, dans lequel ladite électrode de source et/ou ladite électrode de drain comprennent de l'Au et du LiF en un rapport en poids situé dans la plage allant de 1/10 à 10/1.

3. Transistor à effet de champ organique selon la revendication 2, dans lequel ladite électrode de source et/ou ladite électrode de drain comprennent de l'Au et du LiF en un rapport en poids situé dans la plage allant de 1/1 à 4/1.

4. Transistor à effet de champ organique selon la revendication 1, dans lequel ladite électrode de source et/ou ladite électrode de drain comprennent de l'Au et du LiF co-déposés.

5. Transistor à effet de champ organique selon la revendication 4, dans lequel une couche d'Al est déposée au-dessus de ladite couche d'Au/LiF co-déposés.

6. Transistor à effet de champ organique selon la revendication 1, dans lequel ladite électrode de source et/ou ladite électrode de drain comprennent un contact LiF/Al avec ladite couche de semi-conducteur organique.

7. Transistor à effet de champ organique selon la revendication 1, dans lequel ladite couche de semi-conducteur organique comprend un mélange d'$OC_1C_{10}$-PPV/PCBM en un rapport en poids situé dans la plage allant de 0,5/1 à 5/1.

8. Transistor à effet de champ organique selon la revendication 1, dans lequel ladite couche de semi-conducteur organique comprend des traces d'un solvant organique.

9. Transistor à effet de champ organique selon la revendication 8, dans lequel ladite couche de semi-conducteur organique comprend des traces d'au moins un solvant organique choisi dans le groupe composé du chlorobenzène, du 1,2-dichlorobenzène et du xylène.

10. Procédé pour préparer un transistor à effet de champ organique, comprenant les étapes suivantes:

   - disposer une électrode de grille ou former une électrode de grille sur un substrat,
   - déposer sur ladite électrode de grille une couche isolante, de préférence une couche de $SiO_2$,

   **caractérisé en ce que**

   - sur ladite couche isolante, est déposée une couche de semi-conducteur organique comprenant un mélange d'au moins deux composants, le premier composant étant l'ester méthylique d'acide (6,6)-phényl-$C_{61}$-butyrique et le deuxième composant étant le poly(2-méthoxy-5-(3',7'-diméthyloctyloxy)- 1,4- phénylène- vinylène) ($OC_1C_{10}$-PPV) et/ou le poly(3-hexylthiophène) (P3HT), et
   - une électrode de source et une électrode de drain sont créées indépendamment l'une de l'autre, les deux dites électrodes de source et de drain comprenant du LiF et de l'Al et de l'Au.

11. Procédé selon la revendication 10, dans lequel ladite création desdites électrodes de source et de drain est effectuée par co-déposition d'Au et de LiF en un rapport en poids situé dans la plage allant de 1/10 à 10/1.

12. Procédé selon la revendication 11, dans lequel ladite co-déposition d'Au et de LiF est suivie de la déposition d'une couche d'Al.

13. Procédé selon la revendication 10, dans lequel ladite couche de semi-conducteur organique est déposée à partir d'une solution ou dispersion dans un ou plusieurs solvants organiques.

14. Procédé selon la revendication 10, dans lequel ladite couche de semi-conducteur organique est déposée par séchage par pulvérisation.

Au or LiF/Al or LiF:Au/Al top contacts

(*source* and *drain electrodes*) (1)

Organic semiconductor
layer (2)

←— SiO₂

(3)

**p⁺ Si**

←— Al-contact (*gate*) (4)

| Holes | electrons | Holes +<br>electrons |
|---|---|---|
| Au | Al    Al | Al |
| | ↓<br>LiF | ↓<br>Au:LiF |

Fig.1

Fig.2

**OC₁C₁₀-PPV**

Fig.3

Fig.4

Fig.5

Fig.6a

Fig.6b

Fig.7

Fig.8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5629530 A
- US 5596208 A

### Non-patent literature cited in the description

- **Schön et al.** *Science,* 2000, vol. 287, 1022-1023
- **Tada et al.** *Jpn. J. Appl. Phys.,* 1997, vol. 36 (6A), L718
- **Balberg.** *Applied Physical Letters,* 09 July 2001, vol. 79
- CP544, Electronic Properties of Novel Materials. **Geens et al.** Molecular Structures. Americal Institute of Physics, 516-520
- **Brabec.** *Synthetic Metals,* vol. 121, 1517-1520
- **Geens et al.** 14th Internat Winterschool/Euroconference. *AIP Conference Proceedings,* 2000, vol. 544, 516-520
- **Brabec et al.** *Synthetic Metals,* 2001, vol. 121, 1517-1520